# EUROPEAN PATENT APPLICATION

(11) **EP 2 001 040 A2**
(43) Date of publication of application: **10.12.2008**
(21) Application number: 08150110.8
(22) Date of filing: 09.01.2008
(51) Int. Cl.: H01L 21/00, B23K 26/40

(54) **Machine for removing surfaces of semiconductors and particularly surfaces with integrated circuits**

(30) Priority: 08.06.2007 IT PD20070201
(71) Applicant: Helios Technology S.r.L., 35010 Carmignano di Brenta (PD) (IT)
(72) Inventor: Traverso, Franco, 35010, CARMIGNANO DI BRENTA PD (IT)
(74) Representative: Modiano, Micaela Nadia

(57) **Abstract**

A machine for removing surfaces of semiconductors, particularly surfaces with integrated circuits, comprising:
- laser emitter means (11, 111), the at least one beam (12, 112a, 112b, 112c, 112d) of which is designed to strike at least one semiconductor wafer (13, 113, 113a) or at least one fragment thereof, for ablation of a surface layer of preset thickness (A),
- supporting means (14, 114) for the at least one wafer (13, 113, 113a) or fragment thereof,
- means (15, 115) for the relative movement of the emitter means (11, 111) with respect to the at least one wafer (13, 113, 113a) or fragment thereof, said movement means (15, 115) being adapted to make the emitter means follow a path such that the at least one beam (12, 112a, 112b, 112c, 112d) emitted thereby travels over the entire surface to be removed of the at least one wafer (13, 113, 113a) or fragment thereof.

## Description

The present invention relates to a machine for removing surfaces of semiconductors and particularly surfaces with integrated circuits.

An integrated circuit or chip is an electronic device constituted by the integration of an electronic circuit on a substrate of semiconductor material (generally silicon, but sometimes also gallium arsenide or other similar and equivalent materials).

The manufacturing cost of an integrated circuit (hereinafter IC) varies little or not at all as its complexity increases, and therefore it is much more economical to develop complex circuits, composed of a series of internal stages which are interconnected to each other and to the outside and centralize all the functions required for a specific apparatus.

For this reason, the microelectronics industry offers a relatively small number of generic ICs but tens of thousands of specialized ICs, each designed for a specific purpose, thus becoming precious company know-how.

Each technological solution devised by the company gives rise to intellectual and industrial property rights, which may be protected by patenting, but most of all these technological solutions are generally covered by corporate industrial confidentiality, and for this reason the manufacturing company takes steps to hide jealously their technical content from the attentions of its competitors.

The initial material for manufacturing an IC is a circular portion of semiconductor, known as substrate; this material, which is generally already weakly doped, is further doped by ion implantation or by thermal diffusion in order to create active regions for the subsequent provision of a series of identical predefined circuits arranged side by side; a series of thin layers of different materials, such as layers of polycrystalline semiconductor, thin insulating layers, oxide insulating layers, and metallic layers (silicides or metals, such as for example aluminum, tungsten, or more rarely copper) for the electrical connections are then deposited and grown by epitaxy or thermally.

Each new IC, as mentioned, gives rise to intellectual and/or industrial property rights, which during the disposal of the product which has not been used or has been discarded cause problems linked to the need to make it impossible for unlicensed third parties to copy and reproduce the content of said unused integrated circuits.

Currently, in order to prevent competitors from getting their hands on the intellectual property that is present on rejected circuits by means of industrial espionage operations, these rejected integrated circuits are pulverized by grinding.

This grinding is performed, at substantial costs, by specialized companies which are called to work under the watchful supervision of an observer of the manufacturer of the circuits to be destroyed, who must check that the authorized personnel proceeds appropriately so that all the rejected circuits are pulverized adequately.

This grinding operation entails two kinds of risk: a first risk linked to the loyalty of the authorized personnel, and a second more tangible one linked to the fact that pulverization does not always reduce the circuits to a size which makes them unusable; in some cases, it is in fact possible to reconstruct even from microscopic grains of a microchip the intellectual property that it bears.

Further, grinding causes the loss of all the wafer of silicon or other equivalent semiconductor on which the circuits are provided, with a useless waste of raw material.

As an alternative, techniques for the chemical washing of the surfaces of the circuits are known, but they have proved to be very complicated and expensive in terms of machinery, in terms of disposal of the solvents used, and in terms of labor.

The aim of the present invention is to provide a machine for removing surfaces of semiconductors, particularly of surfaces of integrated circuits, which is capable of obviating the drawbacks shown by the described techniques and by known types of machine.

Within this aim, an object of the present invention is to provide a machine for removing surfaces of semiconductors which eliminates every trace of the integrated circuits from the surface of a semiconductor wafer, rendering impossible any copying or reconstruction attempt by third parties.

Another object of the present invention is to provide a machine for removing surfaces of semiconductors which allows to recover at least part of the semiconductor wafer.

Another object of the present invention is to provide a machine which can be programmed to operate automatically and therefore can be managed even by a small number of operators with limited qualification.

Another object of the present invention is to provide a machine for removing surfaces of semiconductors, particularly surfaces of integrated circuits, which can be manufactured with known systems and technologies.

This aim and these and other objects which will become better apparent hereinafter are achieved by a machine for removing surfaces of semiconductors, particularly surfaces with integrated circuits, characterized in that it comprises:
- laser emitter means, the at least one beam of which is designed to strike at least one semiconductor wafer or at least one fragment thereof for ablation of a surface layer of preset thickness,
- supporting means for said at least one wafer or fragment thereof,
- means for the relative movement of the emitter means with respect to the at least one wafer or fragment thereof, said movement means being adapted to make the emitter means follow a path such that the at least one beam emitted thereby travels over the entire surface of the at least one wafer or fragment thereof to be removed.

Further characteristics and advantages of the invention will become better apparent from the following detailed description of two preferred but not exclusive embodiments thereof, illustrated by way of non-limiting example in the accompanying drawings, wherein:
Figure 1 is a schematic perspective view of a machine according to the invention in a first embodiment thereof;
Figure 2 is a schematic front view of a machine according to the invention in a second embodiment thereof;
Figure 3 is a side view of the machine in its second embodiment of Figure 2;
Figure 4 is a sectional side view of an ablation performed with the machine according to the invention.

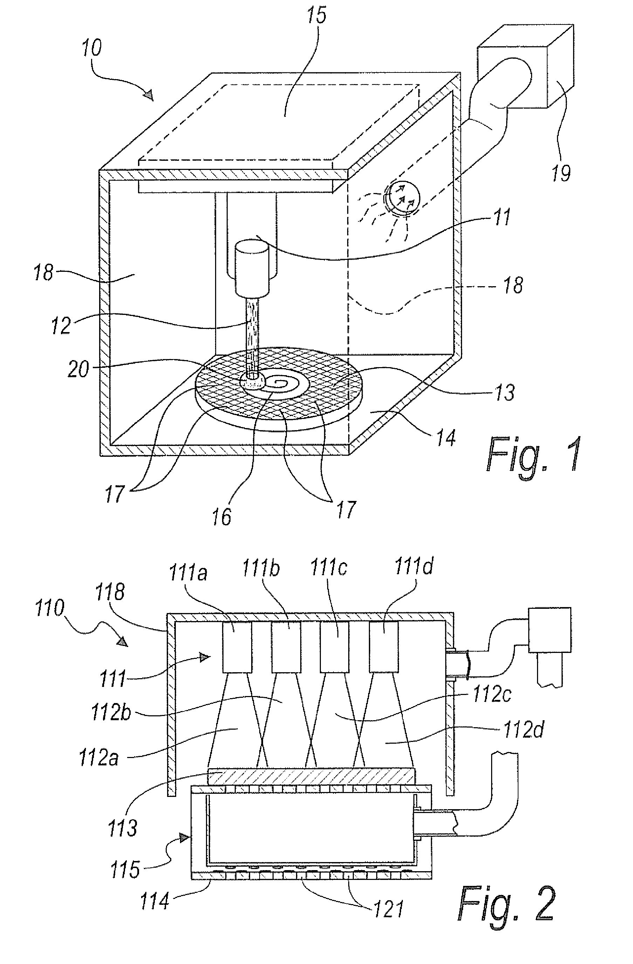

With reference to the figures, a machine for removing surfaces of semiconductors, particularly surfaces with integrated circuits, according to the invention, is generally designated by the reference numeral 10 in its first embodiment, shown schematically in Figure 1.

The machine 10 comprises laser emitter means 11, the at least one beam 12 of which is designed to strike an underlying semiconductor wafer 13 for the ablation of a surface layer 14 having a preset thickness A.

In this first embodiment, which as mentioned is a non-limiting example of the invention, the emitter means 11, described more clearly hereinafter, emit a single laser beam 12.

The machine 10 is intended to process a single wafer 13 or a fragment thereof; the wafers 13 can in fact also occur in broken or partly crumbled form.

The machine 10 further comprises supporting means for said at least one wafer 13 or fragment thereof, for example a supporting surface 14.

The machine 10 further comprises means 15 for the relative movement of the emitter means 11 with respect to the wafer 13 or fragment thereof; said movement means are adapted to make the emitter means follow such a path that the beam 12 that said means emit travels over the entire surface of the wafer 13 or fragment thereof to be removed.

Figure 1 shows by way of example that the movement means 15, of per se known type, allow a spiral motion 16 of the emitter means 11 from the center toward the outer edge of the wafer 13.

The microchips 17 provided on the surface of the wafer 13 are shown schematically thereon and are designed to be removed by the action of the laser beam 12.

The laser emitter means 11 are placed to work safely within a hood 18, partially shown in broken lines, with which suction means, for example a pump, and filtration means 19 for eliminating the gases of the substances sublimated by the action of the laser beam 12, are associated; said gases of sublimated substances, as they move away from the sublimation region toward regions at a lower temperature, tend to solidify and fall in the vicinity, and therefore the suction means 19 avoid the accumulation of debris within the hood 18 in which the emitter means 11 operate.

As mentioned, the emitter means 11 comprise a laser emitter of the Nd:Yag (Neodymium-doped Yttrium Aluminum Garnet) crystal type or of a similar and equivalent type.

The emitter means 11 are adapted to emit a pulsed beam 12 ("Q-switched" beam in the jargon) with a frequency between 10 and 30 kHz and a wavelength of 1064 nm.

The power of said laser emitter is approximately 500 nominal watts.

The laser pulses, with an extremely high specific energy, each act on a region with a surface of approximately 0.3 x 0.3 mm², with an overlap area between one region and the next; said overlap area is preferably approximately 50% of the region struck by the single laser pulse.

The term "approximately" as herein used is meant to indicate that the values to which it applies may vary within the ranges well known by the one skilled in the art as usual in the pertinent field.

The operation of the machine 10 is as follows.

After positioning the wafer 13 on the supporting surface 14 and centering it with respect to the laser emitter, ablation is started.

The pulsed laser beam 12 strikes the central region of the wafer 13 and is then moved so as to trace an outward spiral path in order to cover the entire surface of the wafer 13.

The laser pulses form a plasma (ionized gas at an extremely high temperature, generally between 5000 and 9000 °C), schematically indicated in the figures by a cloud 20.

The combined action of the powerful energy impact of the pulsed laser beam 12 and of the high temperature of the plasma 20 generated in the region where the laser pulse acts determines a change of state (sublimation) of the elements, be they metals, oxides, nitrides, silicon or others, that are present on the surface of the wafer 13, to a depth A which can be preset, by adjusting appropriately the emitter means 11, and typically ranges from 1 to 20 microns.

These elements, which compose the microchips 17 on the surface of the wafer 13, pass from the solid state to the gaseous state in a few microseconds and are lifted off the silicon surface of the wafer 13 by way of the energetic and sequential action of the laser pulses.

These gases of sublimated compounds, once they have moved away from the sublimation point, flow toward the peripheral region of the plasma bubble 20, centrifugally toward regions at a lower temperature, where they cool and solidify.

The suction means 19 remove said solidified gases so as to prevent the resulting solid particles from depositing back onto the surface of the wafer 13.

The action of the machine 10 according to the invention therefore consists in removing and extracting simultaneously and rapidly, in a single pass, the elements and/or layers of organic and inorganic material that are present on the surface of semiconductor wafers 13, regardless of the way in which said elements and/or layers had been deposited on the wafer 13, by interstitial diffusion, by ion implantation, by epitaxial deposition, or other similar and equivalent operation.

These elements and/or layers generally define the microchips 14, which have a thickness B of generally less than 1 micron.

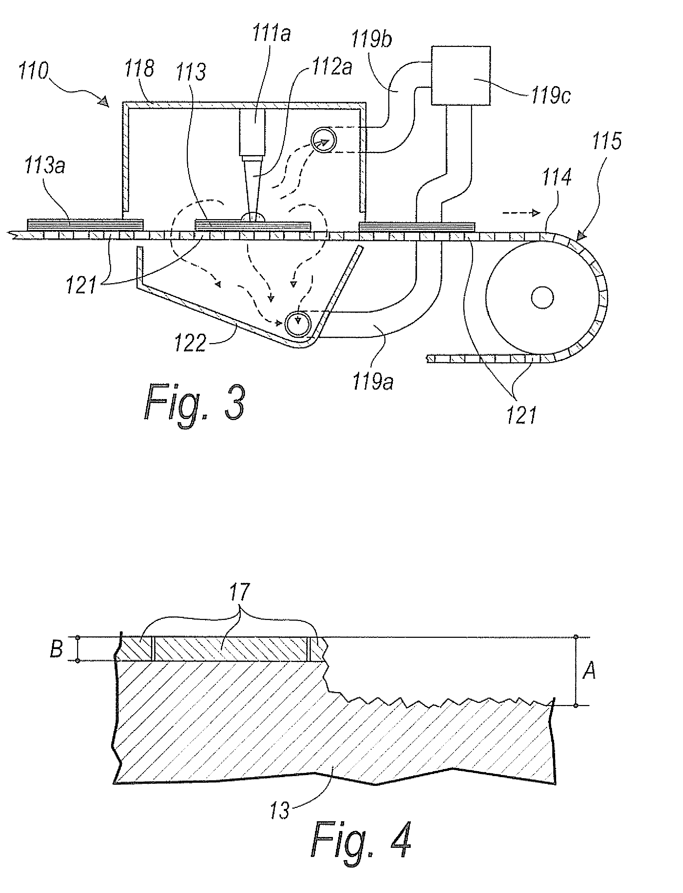

During the action of the emitter means 11, in addition to the layer of microchips 14, a part of the silicon, which is part of the substrate, also is sublimated and removed, as exemplified in Figure 4, but most of the wafer 13 is preserved and available for subsequent recycling operations.

This process which the machine 10 is designed to perform can be performed on various types of semiconductor, not only silicon, both in whole form and in the form of fragments of broken wafers 13.

In its second embodiment, shown schematically in Figures 2 and 3 and designated therein by the reference numeral 110, the machine according to the invention is provided with laser emitter means 111, which comprise a series of emitters arranged side by side, which in the described example are four, respectively 111a, 111b, 111c and 111d.

The respective beams 112a, 112b, 112c and 112d overlap the beam produced by the laterally adjacent emitter, so as to work safely without the risk that regions of the surface being processed might remain unetched by the action of the lasers.

The beams 112a onward therefore affect as a whole a band of such size as to affect the wafer 113 to be processed along its entire width.

The emitters 111a onward are arranged side by side in a perpendicular direction with respect to a conveyor belt 114, which forms the supporting surface for a series of subsequent wafers 113, 113a or a fragment thereof, which are loaded onto the belt 114.

The belt 114, by rotating, moves the wafers, one after the other, below the hood 118 in which the emitters 111a onward work.

In this second embodiment of the invention, which is also a non-limiting example of the invention, the suction and filtration means comprise first suction means 119a, second suction means 119b and the filtration or filtering means 119c.

The first suction means 119a work below the conveyor belt 114 at the hood 118.

The conveyor belt 114 is provided with holes 121, so that the suction induced inside a suction chamber 122 provided below the hood 118 causes the wafers 113 onward to cling to the belt 114, so that they maintain their position during the ablation operation, and simultaneously sucks the gases and debris dust for cooling the gases.

The conveyor belt 114 also constitutes the means for relative movement 115 between the emitter means 111 and the supporting means (constituted indeed by the belt 114).

The second suction means 119b aspirate the gases from the upper part of the hood 118.

The first suction means 119a and the second suction means 119b are both connected to the filtration means 119c, constituted by filters of a known type which are adapted to retain the aspirated harmful substances.

The machine 110 can thus operate continuously and dispose rapidly of large quantities of semiconductor wafers, cleaning them perfectly from the microchips provided thereon in a manner similar to what can be achieved with the machine 10 in its first embodiment.

It has been calculated that with such a machine 110 it is possible to clean 150 to 200 wafers with an 8-inch diameter per hour, and ideally between 3600 and 4800 wafers per day.

The operating principle of the emitters 111a onward is entirely similar to what has been described for the Nd:Yag crystal emitter means of the first embodiment 10 of the invention.

The applications of the machine 10 and 110 according to the invention can be numerous, particularly in the electronics sector.

The machine 10 and 110 allows to remove, simply by using electric power and therefore without resorting to particularly expensive and complex chemical plants, all the circuits, patterns, layers, both metallic and nonmetallic, deposited in various manners on the surfaces of the semiconductor wafers 13 and 113 or of fragments thereof.

The overlap of the laser pulses on the surface of the wafer to be treated ensures total removal of the integrated circuits which contain intellectual property, consequently making it impossible for third parties to copy and/or use this intellectual property in any way.

In practice it has been found that the invention thus described achieves the intended aim and objects.

In particular, the present invention provides a machine for removing surfaces of semiconductors which eliminates every trace of the integrated circuits from the surface of a semiconductor wafer, rendering impossible any attempt at copying or reconstruction by third parties.

Further, the invention provides a machine for removing surfaces of semiconductors which allows to recover much of the semiconductor wafer from which the surface layer containing the microchips has been removed; the saved semiconductor material can be recycled with known techniques.

Moreover, the present invention provides a machine which can be programmed to operate automatically and therefore can be managed even by a small number of operators with limited qualifications.

Moreover, the present invention provides a machine for removing surfaces of semiconductors, and particularly surfaces of integrated circuits, which can be manufactured with known systems and technologies.

The invention thus conceived is susceptible of numerous modifications and variations, all of which are within the scope of the appended claims; all the details may further be replaced with other technically equivalent elements.

In practice, the materials employed, so long as they are compatible with the specific use, as well as the dimensions, may be any according to requirements and to the state of the art.

The disclosures in Italian Patent Application No. PD2007A000201 from which this application claims priority are incorporated herein by reference.

Where technical features mentioned in any claim are followed by reference signs, those reference signs have been included for the sole purpose of increasing the intelligibility of the claims and accordingly such reference signs do not have any limiting effect on the interpretation of each element identified by way of example by such reference signs.

## Claims

1. A machine for removing surfaces of semiconductors, particularly surfaces with integrated circuits, **characterized in that** it comprises:
- laser emitter means (11, 111), the at least one beam (12, 112a, 112b, 112c, 112d) of which is designed to strike at least one semiconductor wafer (13, 113, 113a) or at least one fragment thereof for ablation of a surface layer of preset thickness (A),
- supporting means (14, 114) for said at least one wafer (13, 113, 113a) or fragment thereof,
- means (15, 115) for the relative movement of the emitter means (11, 111) with respect to the at least one wafer (13, 113, 113a) or fragment thereof, said movement means (15, 115) being adapted to make the emitter means follow a path such that the at least one beam (12, 112a, 112b, 112c, 112d) emitted thereby travels over the entire surface to be removed of the at least one wafer (13, 113, 113a) or fragment thereof.

2. The machine according to claim 1, **characterized in that** said emitter means (11, 111) comprise at least one laser emitter of the Nd:Yag crystal type or of a similar and equivalent type.

3. The machine according to the preceding claims, **characterized in that** said emitter means (11, 111) are adapted to emit a beam (12, 112a, 112b, 112c, 112d) which is pulsed with a frequency between 10 and 30 kHz and a wavelength of 1064 nm.

4. The machine according to the preceding claim, **characterized in that** said emitter means (11, 111) have a power level of approximately 500 nominal watts.

5. The machine according to one or more of the preceding claims, **characterized in that** said laser pulses form a plasma (20) in the region where the laser pulse acts, said plasma (20), in cooperation with the action of said laser pulse, causing sublimation of the elements that are present on the surface of the wafer (13), to a depth (A) which can be preset by adjusting the emitter means (11) appropriately.

6. The machine according to one or more of the preceding claims, **characterized in that** said laser pulses, with an extremely high specific energy, each act on a region of surface which measures approximately 0.3 x 0.3 mm².

7. The machine according to the preceding claim, **characterized in that** said laser pulses occur one after the other with an overlap area between one region of struck surface and the next, said overlap area being preferably approximately 50% of the region struck by the individual laser pulse.

8. The machine according to one or more of the preceding claims, **characterized in that** said supporting means for said at least one wafer (13) or fragments thereof are constituted by a supporting surface (14).

9. The machine according to one or more of the preceding claims, **characterized in that** said movement means (15) allow a spiral movement (16) of the emitter means (11) from the center toward the outer edge of the wafer (13) or vice versa.

10. The machine according to one or more of the preceding claims, **characterized in that** said laser emitter means (11, 111) are arranged so as to work safely within a hood (18, 118), with which suction and filtering means (19, 119a, 119b, 119c) for eliminating the gases of the substances sublimated by the action of the laser beam are associated.

11. The machine according to one or more of the preceding claims, **characterized in that** said laser emitter means (111) comprise a series of emitters arranged side by side (111a, 111b, 111c, 111d).

12. The machine according to the preceding claim, **characterized in that** the respective beams (112a, 112b, 112c, 112d) of said emitters arranged side by side (111a, 111b, 111c, 111d) overlap the beam produced by the laterally adjacent emitter, so as to work without the risk of regions of the surface being processed remaining unetched by the action of the lasers.

13. The machine according to the preceding claim, **characterized in that** said beams (112a, 112b, 112c, 112d) form as a whole a band whose dimensions are such as to affect the wafer (113) along its entire width.

14. The machine according to one or more of the preceding claims, **characterized in that** said movement means (115) are constituted by a conveyor belt (114) which forms the supporting surface for a series of successive wafers (113, 113a) or a fragment thereof, which are loaded onto the belt (114), said emitters (111a, 111b, 111c, 111d) being arranged side by side in a direction which is perpendicular to said belt (114).

15. The machine according to one or more of the preceding claims, **characterized in that** said belt (114), by rotating, places the wafers, one after the other, below the hood (118) in which the emitters (111a, 111b, 111c, 111d) work.

16. The machine according to the preceding claim, **characterized in that** said suction and filtration means comprise first suction means (119a), which are adapted to work below the conveyor belt (114) at the hood (118), second suction means (119b) which are suitable to aspirate the gases from the upper part of the hood (118), said first means (119a) and said second means (119b) being connected to the filtration means (119c), constituted by filters of a known type which are adapted to retain the aspirated harmful substances.

17. The machine according to the preceding claim, **characterized in that** said conveyor belt (114) is perforated with holes (121), so that the partial vacuum induced inside a suction chamber (122) provided below the hood (118) makes the wafers (113) onward cling to the belt (114), so that they maintain their position during the ablation operation, and simultaneously aspirates the gases and debris dust for cooling the gases.
